# EUROPEAN PATENT APPLICATION

(11) **EP 1 093 161 A1**
(43) Date of publication of application: **18.04.2001**
(21) Application number: 00308926.5
(22) Date of filing: 11.10.2000
(51) Int. Cl.: H01L 21/768

(54) **Method and composite arrangement inhibiting corrosion of a metal layer following chemical mechanical polishing**

(30) Priority: 12.10.1999 US 158372 P; 28.04.2000 US 560634
(71) Applicant: Applied Materials, Inc., Santa Clara, California 95054 (US)
(72) Inventor: Wijekoon, Kapila, Santa Clara, CA 95050 (US); Bennett, Doyle Edward, Santa Clara, CA 95051 (US); Tsai, Stan D., Fremont, CA 94555 (US); Brown, Brian J., Palo Alto, CA 94301 (US); Chandrachood, Madhavi, Sunnyvale, CA 94086 (US); Redeker, Fred C., Fremont, CA 94539 (US)
(74) Representative: Bayliss, Geoffrey Cyril

(57) **Abstract**

High through-put CMP is achieved with a corrosion resistant metal layer by a multi-step polishing technique. Embodiment of the present invention include forming a copper containing layer (60) on a substrate (10); polishing the copper containing layer to substantially planarize and expose a surface of the layer; buffing the substrate having the substantially planarized and exposed copper containing layer with a buffing pad; rinsing the buffed substrate with a solution comprising up to about 1 weight percent of benzotriazole in deionized water subsequent o or during buffing to form a corrosion inhibiting layer of benzotriazole on the copper containing layer; and separating the substrate from the buffing pad without applying substantial pressure between the substrate and the buffing pad such that the benzotriazole layer remains substantially intact and prevents corrosion of the copper containing layer.

## Description

The present invention generally relates to a corrosion resistant metal layer on a semiconductor substrate and a method of forming the corrosion resistant metal layer. In particular, the present invention relates to a method of polishing a semiconductor substrate having a copper layer thereon to form a corrosion resistant copper layer following chemical mechanical polishing. The present invention is applicable to manufacturing integrated circuits having submicron design features and high conductivity interconnect structures.

Integrated circuits are typically formed on substrates, particularly semiconductor substrates, such as silicon wafers, by sequentially depositing and etching conductive, semiconductive and/or insulative layers to ultimately form a plurality of features and devices. The active devices, which are initially isolated from one another, are interconnected to form functional circuits and components through the use of well-known multilevel interconnections.
metallization, and frequently third and subsequent levels of metallization. Interlevel dielectrics, such as doped and undoped silicon dioxide, are used to electrically isolate the different levels of metallization in a silicon substrate. Typically, conductive patterns on different layers, i.e. upper and lower layers, are electrically connected by a conductive plug filling a via hole, while a conductive plug filling a contact hole establishes electrical contact with an active region on a semiconductor substrate, such as a source/drain region. Conductive lines are formed in trenches which typically extend substantially horizontal with respect to the semiconductor substrate. Semiconductor "chips" comprising five or more levels of metallization are becoming more prevalent as device geometries shrink to submicron levels.

A conductive plug filling a via hole is typically formed by depositing an interlayer dielectric on a conductive layer comprising at least one conductive pattern, forming an opening through the interlayer dielectric by conventional photolithographic and etching techniques, and filling the opening with a conductive material, such as tungsten. Excess conductive material on the surface of the dielectric interlayer is typically removed by chemical mechanical polishing (CMP). One such method is known as damascene and basically involves forming an opening in the dielectric interlayer and filling the opening with a metal. Dual damascene techniques involve forming an opening comprising a lower contact or via hole section in communication with an upper trench section. The entire opening is filled with a conductive material, typically a metal, to simultaneously form a conductive plug in electrical contact with a conductive line.

Conventionally, aluminum has been used as the primary metal for interconnect circuitry. Aluminum has relatively low electrical resistance and is easy to deposit and etch into circuit patterns. However, the use of aluminum for future devices is limited due to its inability to reliably carry electrical current in smaller-sized circuit lines. After years of development, copper is now starting to enter mainstream use in semiconductor manufacturing. Copper has lower resistance than aluminum, so it can carry more current in a smaller area, enabling faster and denser chips with increased reliability and computing power. In addition, copper has improved electrical properties *vis-à-vis* tungsten, making copper a desirable metal for use as a conductive plug as well as conductive wiring.

Unfortunately, the use of copper interconnects has created new difficulties in the manufacturing methodology of integrated circuits. For example, copper has a propensity to diffuse through interdielectric layer materials, such as silicon dioxide, requiring copper interconnect structures to be encapsulated by a diffusion barrier layer. Typical diffusion barrier metals include tantalum (Ta), tantalum nitride (TaN), titanium nitride (TiN), titanium-tungsten (TiW), tungsten (W), tungsten nitride (WN), titanium-titanium nitride (Ti-TiN), titanium silicon nitride (TiSiN), tungsten silicon nitride (WSiN), tantalum silicon nitride (TaSiN) and silicon nitride for encapsulating copper (Cu). The use of such barrier materials to encapsulate Cu is not limited to the interface between Cu and the dielectric interlayer, but includes interfaces with other metals as well. Further the use of copper interconnections has created planarization and corrosion difficulties.

CMP is one method of planarizing layers formed on a semiconductor substrate and for removing excess metal deposited in the formation of conductive patterns. In conventional CMP techniques, a semiconductor substrate in need of planarization is mounted on a carrier or polishing head. The exposed surface of the substrate is then placed against a rotating polishing pad which in turn is mounted on a rotating platen driven by an external driving force. The carrier provides a controllable force, i.e. pressure, urging the substrate against the rotating polishing pad. Additionally, the carrier may rotate to affect the relative velocity distribution over the surface of the substrate. A polishing slurry, including an abrasive and at least one chemically-reactive agent, may be distributed over the polishing pad to provide an abrasive chemical solution at the interface between the pad and substrate.

The slurry initiates the polishing process by chemically reacting with the layer being polished. The polishing process is facilitated by the rotational movement of the pad relative to the substrate as slurry is provided to the substrate/pad interface. Polishing is continued in this manner until the desired layer is planarized to an appropriate level. The slurry composition is an important factor in the CMP step. Depending on the choice of the oxidizing agent, the abrasive, and other useful additives, the polishing slurry can be tailored to provide effective polishing to metal layers at desired polishing rates while minimizing surface imperfections, defects and corrosion and erosion.

Typically CMP polishing slurries contain an abrasive material, such as silica or alumina, suspended in an oxidizing, aqueous medium. Additional components can be added to the slurry to improve certain aspects of the planarizing process. For example, benzotriazole has been added to slurry compositions together with the oxidants and abrasives (see, e.g. U.S. Patent No. 5,664,989).

In applying conventional planarization techniques, such as CMP, to Cu, it is extremely difficult to achieve a high degree surface uniformity, particularly across a surface extending from a dense array of Cu features, e.g., Cu lines, bordered by an open field. A dense array of metal (Cu) features is typically formed in an interlayer dielectric, such as a silicon oxide layer, by a damascene technique wherein trenches are initially formed. A barrier layer, such as a Ta-containing layer is then deposited lining the trenches and on the upper surface of the silicon oxide interlayer dielectric. Cu or a Cu alloy is then deposited by conventional copper or copper alloy forming techniques. Excess Cu or Cu alloy is then removed, by one or more polishing steps including employing different polishing pads under different polishing conditions, the barrier layer and any remaining Cu or Cu alloy is then removed by yet another polishing step. Finally excess slurry and/or particles are removed from the planarized surface by rinsing the substrate, typically with deionized water.

After planarizing and exposing the bare metal surface to deionized water, there is a propensity for the metal, particularly Cu or a Cu alloy, to oxidize or corrode in the aqueous environment. Corrosion is particularly problematic in interconnect structures because the corroded metal is unable to reliably carry electrical current in smaller-sized circuit lines. In fact, it has been observed that corrosion can be as high as 50 -60 Å after a CMP process of a copper film.

Further, any component of the slurry or polishing process that may have been added to protect the planarized metal film during the CMP process is likely to be removed or stripped during the CMP process itself, or washed away upon the rinse step or removed by the process of removing the substrate from the polishing pad.

Typically, the carrier head is used to remove the substrate from the polishing pad after one stage of the polishing process has been completed. In this process, a carrier head is pushed down on the back side of the substrate to form a fluid tight seal between the carrier head and the substrate. Vacuum is then applied to the backside of the pinned substrate forming a vacuum tight seal between the carrier head and the substrate causing the substrate to be vacuumed chucked to the carrier head. After the substrate has been vacuumed chucked, the carrier head is retracted pulling the substrate off of the polishing pad. Under certain circumstances and conditions, the substrate removal process may also remove any corrosion protection that may have been developed during CMP rendering the bare metal film susceptible to significant corrosion, particularly since the polished metal film, at this point, is still wet from the rinse step.

Hence, a continuing need exists for protecting planarized and polished metal films subsequent to CMP from oxidation and corrosion.

An aspect of the present invention is a corrosion resistant copper metallization.

An additional aspect of the present invention is a method of forming a corrosion resistant metal layer over a semiconductor substrate following CMP.

Additional aspects and other features of the present invention will be set forth in part in the description which follows and in part will become apparent to those having ordinary skill in the art upon examination of the following or may be learned from the practice of the invention. The aspects of the invention may be realized and obtained as particularly pointed out in the appended claims.

According to the present invention, the foregoing and other aspects are achieved in part by a composite arrangement comprising a semiconductor substrate having a metal layer thereon and a corrosion inhibiting amount of an inhibitor on the metal layer. The corrosion resistant inhibitor advantageously passivates the metal layer from oxidation and can be formed by applying at least one compound that substantially inhibits the interaction of oxygen or other corrosive substances, such as water or ions in an aqueous solution, from deleteriously interacting with a newly exposed metal surface.

Embodiments of the present invention include a composite arrangement comprising a semiconductor substrate having a copper containing layer on the semiconductor substrate and a corrosion inhibiting amount of an amine compound, e.g. Triazole ("TTA") or benzotriazole ("BTA"), on the copper containing layer. The corrosion inhibiting layer can be formed up to about 25 nm, e.g., from about 0.5 nm to about 4.0 nm..

In a further embodiment of the present invention, the composite arrangement comprises: a semiconductor substrate; a dielectric layer, such as a silicon oxide layer, on the semiconductor substrate; a barrier layer, such as a Ta-containing barrier layer, e.g. Ta, TaN or TiN, on the dielectric layer; a metal layer, e.g. a copper or copper alloy layer, on the barrier layer; and a corrosion inhibiting amount of an inhibitor, e.g. benzotriazole or triazole, on the metal layer.

Another aspect of the present invention is a method of planarizing and forming a corrosion resistant metal layer, e.g. a copper containing layer, on a semiconductor substrate. The method comprises: forming a metal layer over the substrate; polishing the metal layer, as with a chemical mechanical polisher, to substantially planarize and expose a surface of the metal layer; and applying a composition to form a corrosion inhibiting layer on the exposed surface of the metal layer.

By this method, the potential conductive loss, due to oxidation and corrosion, of the exposed polished metal film is minimized, if not eliminated altogether. It is particularly advantageous to substantially exclude abrasive particles or abrasive components from the applied composition. Abrasives in the applied composition defeat the formation of a passivated metal surface by abrading or otherwise substantially removing the corrosion inhibiting layer formed on the metal surface during the application of the composition.

In accordance with the present invention, the applied composition substantially excludes abrasives, such as those conventionally employed in chemical mechanical polishing slurries, as for example, alumina and silica. In an embodiment of the present invention, the composition comprises a corrosion inhibiting amount of the inhibitor in an aqueous or organic carrier, substantially free of abrasives.

In embodiments of the present invention, a semiconductor substrate having a planarized and exposed metal surface layer thereon is rinsed with a composition comprising an inhibitor, free of abrasives, while the substrate is in contact with a polishing pad, such that there is a pressure of about 0 psi to about 2 psi between the polishing pad and the substrate.

Embodiments of the present invention include a method of planarizing and forming a corrosion resistant metal layer on a semiconductor substrate, comprising: forming a metal layer on the substrate; polishing the metal layer, as with a chemical mechanical polisher, to substantially planarize and expose a surface of the metal layer; transferring the substrate, subsequent to planarization, to a buffing pad; buffing and rinsing the substrate having the substantially planarized and exposed metal layer; and applying an aqueous solution comprising a corrosion inhibitor during the buffing and rinsing step to form a corrosion resistant metal layer, wherein the buffing step does not remove the corrosion resistant metal layer, e.g. there is substantially no pressure between the substrate and the buffing pad during the buffing and rinsing step.

The various features of the present invention will become more apparent and facilitated by reference to the accompanying drawings, submitted for purposes of illustration and not to limit the scope of the invention, where the same numerals represent like structure and wherein:
Fig. 1 shows a composite arrangement of the present invention prior to planarization.
Fig. 2 illustrates a carrier head assembly for holding a semiconductor substrate in accordance with the present invention.

The present invention achieves planarized metal layers, e.g. copper containing layers, with reduced susceptibility to corrosion. In modern semiconductor manufacturing, metallization layers are typically processed by CMP, where material is removed by polishing the metal layer overlaying a semiconductor substrate to expose the underlaying metal features embedded in the substrate. When the underlying metal features are exposed, however, uncontrolled loss of the metal due to corrosion may ensue.

CMP is often performed in a stepwise fashion, for example, when a wafer is partially polished on a number of different polishing pads as part of a continuous process. Corrosion of a freshly revealed metal layer, e.g. a copper containing layer, can occur at the end of any polishing step, particularly when the metal layer is exposed to an aqueous environment. Accordingly, the present invention relates to methods to form and preserve a film of a corrosion inhibitor on the surface of a metal layer following CMP to preserve the planarized metal surface.

As used throughout this disclosure, the term "inhibitor" denotes a compound or compounds capable of preventing substantial oxidation or substantial corrosion of a metal layer. Oxidation and corrosion of a metal layer in turn results in, among other things, a loss in the electrical conductivity, which becomes increasingly significant as design rules shrink.

Useful inhibitors may include urea, thiourea, azole (e.g. benzimidazole), benzothiazole, benzotriazole, triazole, imidazoles, benzoxazole, mercaptobenzoxazole benzimidazole, 2-mercaptobenzoimidazole, tetrazole, mercaptotetrazole, 1-phenyl-5-mercaptotetrazole, imidazole, alkanethiols, tolytriazole, benzohydroxamic acids, 2-amido pyradine, salicylaldoxime, cupferron, ethylenediamine, amino acids containing sulfur (e.g. cysteine), p-aminobenzaldehyde, a halo acetic acid, thiols such as phosphonic acids (e.g., dodecylmercaptan and octanephosphonic acid), monosaccharides such as a glucose and a fructose, derivatives and mixtures of the above-mentioned compounds, N-benzoyl-N-phenylhydroxyamine derivatives, and the like. As discussed herein, a derivative is any other atoms bonded to the film forming agents, as for example, a hydroxy, amino, imino, carboxy, mercapto, nitro and alkyl substituted groups. Other compounds that form a passivating layer or action, i.e. prevents substantial oxidation or otherwise deleterious corrosion of the metal surface upon application of the inhibitor to a metal surface, can also be used. Advantageously, the formed passivation layer can be easily removed as, for example, by the application of heat or by washing. The inhibitor should be present in the composition of this invention in an amount that is capable of promoting the formation of a passivating layer on the metal surface.

In an embodiment of the present invention, the inhibitor is present in an amount up to about 1.0 weight percent of the composition. It is understood that weight percent refers to the weight percent of the item to the total weight of the composition. A surprisingly low concentration of the inhibitor can provide adequate corrosion protection. For example, an amount ranging from about 0.01 to about 0.2 weight percent, e.g. about 0.04 weight percent of the inhibitor, together with deionized water as a carrier and/or solvent can prevent conductive loss resulting from a corroded metal layer.

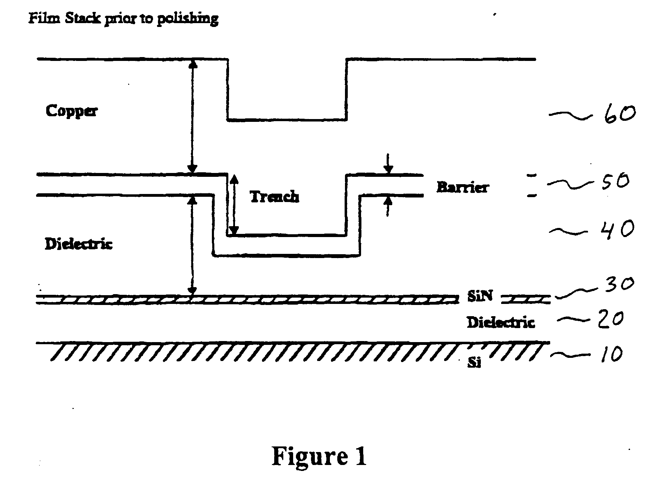

Referring the Figure 1, a composite arrangement of the present invention is illustrated prior to planarization. The composite arrangement comprises silicon substrate 10 having dielectric layer 20 thereon, silicon nitride layer 30 on the dielectric film 20, and a second dielectric film 40, such as a silicon dioxide film, e.g. PETEOS, overlaying silicon nitride 30. Barrier film 50, e.g. a film of Ta, TaN, or TiN, having a thickness of about 200-500 Å overlays dielectric layer 40 and copper layer 60 having an initial thickness of about 5,000-10,000 Å overlays barrier film 50. Planarizing a copper layer, as depicted in Figure 1, of the present invention is achieved by employing a strategic multi-step process.

In practicing the present invention, a multi-step CMP process is employed comprising: CMP of the copper layer employing a conventional polishing pad and stopping on the Ta or TaN barrier layer; removing the Ta or TaN barrier layer; buffing the surface of the silicon oxide interlayer dielectric to reduce or eliminate scratching and defects; and rinsing and protecting the planarized metal surface with a composition comprising a corrosion inhibiting amount of an inhibitor. The contaminants and particles resulting from the CMP are removed by rinsing the polished substrate surface with a solution comprising the inhibitor in deionized water, for example. The corrosion resistant layer can be formed having a thickness of no greater than about 4.0 nm over the planarized copper layer.

A consideration affecting the formed passivated metal film is the handling of the substrate subsequent to planarizing and polishing the metal film. Conventionally, the substrate is removed from the polishing pad by applying a force to the substrate sandwiching the carrier head, substrate and polishing pad together. This method causes frictional forces between the pad and substrate removing any protection that may have been applied to the substrate during the CMP process.

The present invention contemplates that the formation of the corrosion inhibiting film on the surface of a freshly formed copper film is carried out under zero, or very low sheer stress. In an embodiment of the present invention, the formation of the corrosion inhibiting film is carried out at no greater than about 1.5 psi, at the surface of the copper layer during or subsequent to CMP.

Preserving the newly formed corrosion inhibiting film on the metal layer is accomplished by removing the polished substrate from the polishing pad without introducing any sheer stress at the surface of the metal layer. In an embodiment of the present invention, the substrate is removed form the polishing pad free of the application of pressure between the pad and substrate surface. In an embodiment of the present invention, the substrate is removed form the polishing pad at a pressure of no greater than about 1 psi.

A multi-station CMP polishing apparatus is employed in practicing the invention. The CMP apparatus has at least one carrier head for manipulating a semiconductor substrate and at least one platen for receiving and rotating a polishing pad. A detailed description of a CMP apparatus can be found in U.S. Patent No. 5,738,574 and assigned to the assignee of the present invention, the disclosure of which is hereby incorporated by reference.

The carrier assembly is employed both to press the substrate to a. polishing pad and to remove the substrate from the polishing pad after one stage of the polishing process has been completed. Carrier assemblies typically include a housing, a base attached to the housing, a substrate backing assembly, attached to the base, for holding the substrate and a loading mechanism in the housing to provide pressure to the base and substrate backing assembly. A detailed description of a carrier head assembly can be found in U.S. Patent No. 5,957,751 and U.S. patent application Serial No. 08/745,670 by Zuniga et al. filed November 8, 1996, entitled A CARRIER HEAD WITH A FLEXIBLE MEMBRANE FOR A CHEMICAL MECHANICAL POLISHING SYSTEM, both assigned to the assignee of the present invention, both disclosures of which are hereby incorporated in their entirety by reference.

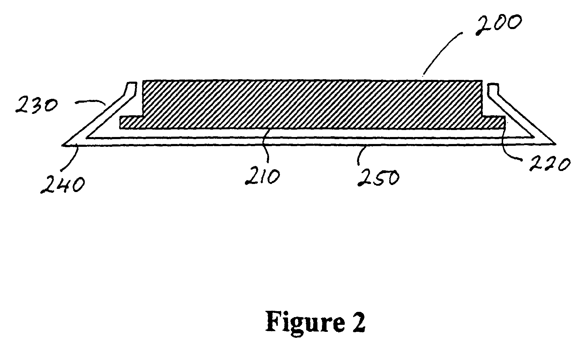

Figure 2 illustrates a support plate, 200, which is part of substrate backing assembly (not show for illustrative convenience) and a flexible member, 230, surrounding support plate 200. The backing assembly would typically be attached to base and housing respectfully (also not shown for illustrative convenience). Support plate 200 may generally be a disk-shaped rigid member having a generally planar lower surface 210 with a horizontally-projecting lip 220 at its outer edge. Support plate 200 may be formed of aluminum or stainless steel. A plurality of apertures (not shown) may extend vertically through support plate 200 to allow communication of a vacuum source with lower surface 210 and membrane 230.

Figure 2 illustrates a carrier head 200 with a flexible membrane 230 secured to a carrier base assembly 210, and a retaining ring 220 (other possible elements in the carrier head are not illustrated for convenience). Flexible membrane 230 is formed of a flexible and elastic material. A lower surface of a central portion 232 of membrane 230 provides a mounting surface 238 for receiving a substrate. A perimeter portion 234 of membrane 230 is clamped between carrier base assembly 210 and retaining ring 220. Alternatively, the perimeter portion of membrane can be secured to a support structure, which can be movably coupled to the carrier base assembly 210. A volume between flexible membrane 230 and carrier base assembly 210 provides a chamber 240 that can be pressurized or evacuated to control the pressure on the substrate. Membrane 230 can also include an outer flap 236 connecting center portion 232 to perimeter portion 234. As discussed in U.S. Patent Application Serial No. 09/296,935, filed April 22, 1999, incorporated herein by reference, outer flap 236 can form a seal with the backside of the mounted substrate. When chamber 240 is evacuated, the substrate is vacuum chucked to the mounting surface 238, and is pulled away from the polishing pad. This vacuum chucking procedure can be performed without applying a substantial downward pressure on the substrate.

In accordance with the present invention, a semiconductor substrate having the composite arrangement shown in Figure 1 is mounted on to a carrier head as, for example, a carrier head having the support plate and flexible member shown in Figure 2, of a CMP apparatus. The exposed surface of the substrate is then placed against a rotating polishing pad, which in turn is mounted on a rotating platen driven by an external driving force. The carrier head provides a controllable force, i.e. pressure, urging the substrate against the rotating polishing pad thereby planarizing and/or polishing the exposed layer on the substrate. After planarization of one layer, the substrate can be placed on a different platen having a different polishing pad for subsequent processing. Given the guidance and objectives of the present disclosure, the optimum polishing conditions can be necessarily determined in a particular situation.

For example, a substrate (consisting of a layer stack of copper, barrier, and oxide) is subjected to processing on three different polishing pads, as shown in the following Table.

**Table**

| Platen | Function | Pad | Rates and Conditions |
|---|---|---|---|
| 1 | Copper removal | Hard | High Rate/Slurry |
| 2 | Barrier film removal | Hard | Low Rate/Slurry |
| 3 | Oxide Buff | Soft | Low Rate |
| | Corrosion Control | | Rinse/ 0.04 wt% |
| | | | BTA in Deionized water |

On the first pad (a hard polishing pad), copper from the field regions is largely, or even entirely, removed. On the second polishing pad (also a hard polishing pad), any remaining copper and the barrier material is removed. At this stage the final copper surface has been exposed and is protected by the inhibitor, e.g. an aqueous solution comprising about 0.04 wt% of BTA, so that no corrosion occurs prior to further processing. To prevent corrosion, the metal layer on the substrate can be rinsed with aqueous BTA on this second pad, or it can be removed from this second pad, transferred to a third pad (a soft polishing pad), and rinsed with aqueous BTA on the third pad. It is advantageous to allow the wafer to contact the third pad under the sole pressure of its own weight (i.e., with chamber 240 of the carrier under vent rather than under pressure) where the low pressure rinsing step on the soft pad can remove particle defects from the pad. It is estimated that the substrate realizes a pressure of about 0.5 psi when contacting the pad under its weight.

In an embodiment of the present invention, a polished copper film is rinsed with a solution comprising a corrosion resistant amount of the inhibitor following polishing but before it is removed from the polishing pad (i.e. dechucked from the pad). Alternatively, the rinse step can be performed on second pad to which the wafer is moved immediately following polishing on the first pad. Although not completely understood, it is believed that the inhibitor, such as certain linear or cyclic passivating amine compounds, prefer the surface of the metal rather than its medium (e.g. an aqueous environment) and form a bond to the metal which prevents oxidants from reacting with the metal surface. In the application of about 0.04 weight percent of benzotriazole in deionized water a hydrophobic surface is formed, as evidenced by the lack of wetting of the passivated copper surface.

An aspect of the present invention resides in preventing removal of the corrosion resistant film formed on the metal layer by subsequent processes. In practicing the present invention, the metal film (e.g. copper or a copper alloy) is not placed under substantial pressure against the polishing pad either during, or subsequent to, the rinse step. If the wafer is placed under pressure during the rinse step, the sheer stress at the surfaced of the copper film will prevent formation of the inhibitor film. In turn, no corrosion protection will attend. If the wafer is not placed under pressure during the rinse step, but is subsequently placed under pressure (e.g. during dechuck), the inhibitor film will form only to be subsequent removed as a result of the dechuck step.

The present invention is applicable to planarizing during various stages of semiconductor manufacturing. The present invention enjoys particular applicability in the manufacture of high density semiconductor devices with metal features in the deep submicron range.

Only the preferred embodiment of the present invention and but a few examples of its versatility are shown and described in the present disclosure. It is to be understood that the present invention is capable of use in various other combinations and environments and is capable of changes and modifications within the scope of the inventive concept as expressed herein.

## Claims

1. A composite arrangement comprising a semiconductor substrate having a metal layer thereon and a corrosion resistant amount of an inhibitor on the metal layer.

2. A composite arrangement as claimed in claim 1, wherein the metal layer comprises a copper containing layer.

3. A composite arrangement as claimed in claim 2, comprising a corrosion inhibiting amount of a passivating amine compound or mixtures thereof as the inhibitor on the copper containing layer.

4. A composite arrangement as claimed in any of claims 1 to 3, wherein the corrosion inhibiting layer has a thickness of up to about 25 nm.

5. A composite arrangement as claimed in any of claims 1 to 4, further comprising a dielectric layer on the semiconductor substrate, a barrier layer on the dielectric layer, the metal layer on the barrier layer and the inhibitor on the metal layer.

6. A method of planarizing and forming a corrosion resistant metal layer on a semiconductor substrate, the method comprising:
forming a metal layer over the substrate;
polishing the metal layer to substantially planarize and expose a surface of the metal layer; and
applying a corrosion inhibiting composition on the polished metal layer to form a corrosion inhibiting layer on the exposed surface of the metal layer.

7. A method as claimed in claim 6, comprising:
polishing the metal layer with a polishing pad;
applying the corrosion inhibiting composition to the polished metal layer; and
separating the substrate from the polishing pad such that the corrosion inhibiting metal layer remains substantially intact.

8. A method as claimed in claim 6, comprising:
buffing the substrate having the substantially planarized and exposed metal layer with a buffing pad;
applying the composition to the substrate subsequent to or during buffing to form the corrosion resistant metal layer; and
separating the substrate from the buffing pad such that the corrosion inhibiting metal layer remains substantially intact.

9. A method as claimed in claim 8, comprising buffing the substrate such that the pressure between the substrate and the buffing pad during the buffing and applying the composition is no greater than about 1 psi.

10. A method as claimed in claim 9, comprising
separating the substrate from the buffing pad free from the application of pressure between the buffing pad and the substrate

11. A method as claimed in any of claims 8 to 10, comprising separating the substrate from the buffing paid.

12. A method as claimed in any of claims 6 to 10, comprising applying a composition substantially free of abrasives as the composition to form the corrosion inhibiting layer on the exposed metal surface.

13. A method as claimed in any of claims 6 to 12, comprising applying an aqueous solution having a corrosion inhibiting amount of an passivating amine compound or mixtures thereof as the composition to form the corrosion inhibiting layer on the exposed surface of the metal layer.

14. A method as claimed in any of claims 6 to 13, comprising applying an aqueous solution comprising up to about 1 weight percent of a corrosion inhibitor as the composition.

15. A method as claimed in any of claims 6 to 14, comprising applying an aqueous solution comprising a cyclic amine compound or mixtures thereof as the composition.

16. A method as claimed in any of claims 6 to 15, comprising applying an aqueous solution comprising from about 0.01 weight percent to about 0.2 weight percent of triazole, benzotriazole, their derivatives or mixtures thereof as the composition.

17. A method of planarizing and forming a corrosion resistant metal layer on a semiconductor substrate, comprising:
forming a copper containing layer on the substrate;
polishing the copper containing layer to substantially planarize and expose a surface of the copper containing layer with a polishing pad;
applying a corrosion inhibiting composition subsequent to or during polishing to form a corrosion inhibiting layer on the copper containing layer; and
separating the substrate from the polishing pad without applying substantial pressure between the substrate and the polishing pad such that the corrosion inhibiting layer remains substantially intact and prevents corrosion of the copper containing layer.

18. A method as claimed in claim 17, comprising buffing the substrate having the substantially planarised and exposed copper containing layer with a buffing pad and applying the corrosion inhibiting composition subsequent to or during buffing to form the corrosion inhibiting layer on the copper containing layer.

19. A method as claimed in claim 17 or claim 18, comprising applying up to about 1 weight percent of benzotriazole in deionized water as the corrosion inhibiting composition.

20. A method as claimed in any of claims 17 to 19, comprising applying a composition substantially free of abrasives as the composition to form the corrosion inhibiting layer on the exposed metal surface.
